(19) Europäisches Patentamt
European Patent Office
Office européen des brevets

(11) **EP 2 747 229 B1**

(12) **EUROPEAN PATENT SPECIFICATION**

(45) Date of publication and mention
of the grant of the patent:
**22.11.2017 Bulletin 2017/47**

(51) Int Cl.:
*H02H 3/28* *(2006.01)*       *H02H 7/045* *(2006.01)*
*G01R 15/18* *(2006.01)*

(21) Application number: **13306656.3**

(22) Date of filing: **03.12.2013**

(54) **Method for predicting and detecting current transformer saturation under sympathetic inrush**

Verfahren zur Voraussage und Erkennung der Stromwandlersättigung unter sympathisierendem Einschaltstrom

Procédé de prédiction et de détection de la saturation d'un transformateur de courant dans un appel de sympathique

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **18.12.2012 CN 201210551425**

(43) Date of publication of application:
**25.06.2014 Bulletin 2014/26**

(73) Proprietor: **Schneider Electric Industries SAS 92500 Rueil-Malmaison (FR)**

(72) Inventor: **Song, Juzhong 201114 Shanghai (CN)**

(74) Representative: **Manitz Finsterwald Patentanwälte PartmbB Martin-Greif-Strasse 1 80336 München (DE)**

(56) References cited:
**WO-A1-02/093710     WO-A2-01/76036**

- **Bogdan Kasztenny: "Operate and Restraint Signals of a Transformer Differential Relay", 54th Annual Georgia Tech Protective Relaying Conference, 5 May 2000 (2000-05-05), XP055117256, Retrieved from the Internet: URL:http://store.gedigitalenergy.com/faq/d ocuments/t35/ger-3992.pdf [retrieved on 2014-05-09]**

## Description

TECHNICAL FIELD

The present disclosure relates to relay protection in a power plant and substation automation system, and in particular to a method for predicting and detecting a current transformer (CT) saturation under a sympathetic inrush. Related technologies are known from documents Bogdan Kasztenny: "Operate and Restraint Signals of a Transformer Differential Relay", 54th Annual Georgia Tech Protective Relaying Conference, 5 May 2000, XP055117256, and WO 02/093710 A1.

BACKGROUND

There are generally several transformers which are connected in parallel or in series in a power system. If one of them is switched on, a sympathetic inrush may occur sometimes among these transformers.

Typically, at a high voltage side and a low voltage side of a transformer, a current transformer for the high voltage side and a current transformer for the low voltage side are disposed, respectively, so that a differential protection for the transformer is realized by these two current transformers. However, a longtime sympathetic inrush may cause a saturation of the current transformer at the high voltage side or the low voltage side, which is used for the differential protection for the transformer, and may in turn lead to a differential protection mal-operation.

After the current transformer at one side is saturated, its inductance would be decreased, which may cause decreasing in an impendence angle of this current transformer and may also lead to decreasing in magnitude of the current output from the current transformer. In this case, a current of the saturated current transformer would lead that of the unsaturated current transformer (that is, the normal current transformer at the other side), and a phasor difference between the current output from the saturated current transformer and the current output from the unsaturated current transformer is referred to as a differential current. As deeper the saturation of the saturated current transformer is, an angle difference between the current output from the saturated current transformer and that output from the unsaturated current transformer would become greater, that is to say, an angle of the differential current would become greater, and a direct current (DC) component in the differential current would become greater too. Finally, when the current transformer at one side is saturated deeply while the current transformer at the other side operates normally, the differential current would be large enough to trigger a differential protection of the transformer such that a differential protection mal-operation occurs.

Currently, in some products for the power substation automation system, for example, Micom P40 platform products from Schneider Company, no measure is taken to prevent the differential protection mal-operation. Further, users often complain about problems caused by such differential protection mal-operation.

Therefore, there is a need for a method for detecting the current transformer saturation and preventing the differential protection mal-operation.

SUMMARY

The present disclosure is proposed in view of the above problems. An appropriate solution is proposed by a method according to claim 1.

Embodiments of the present disclosure provide a method for predicting a current transformer (CT) saturation, which may predict an imminent saturation or a saturation of the current transformer effectively before a differential protection of a transformer is triggered by a current transformer saturation by detecting a current at a high voltage side output from a current transformer disposed on the high voltage side and a current at a low voltage side output from a current transformer disposed on the low voltage side of the transformer under a sympathetic inrush, and performing a current transformer saturation prediction according to their variation characteristics, thus it may prevent a differential protection mal-operation of the transformer effectively.

According to an aspect of the embodiments of the present disclosure, there is provided a method for predicting a current transformer saturation, wherein a first current transformer is connected to a high voltage side of a transformer and a second current transformer is connected to a low voltage side of the transformer, the first current transformer and the second current transformer are used for a differential protection of the transformer, the method for predicting the current transformer saturation comprises: detecting a first current output from the first current transformer and detecting a second current output from the second current transformer; calculating a first fundamental vector, a first Direct Current (DC) component and a first total Root Mean Square (RMS) of the first current, and calculating a second fundamental vector, a second DC component and a second total Root Mean Square of the second current; and generating a prediction signal for the current transformer saturation according to the first fundamental vector, the first DC component, the first total RMS, the second fundamental vector, the second DC component and the second total RMS.

In the method for predicting the current transformer saturation, one of the first fundamental vector and the second fundamental vector whose phase leads is a leading current vector, and the other is a lagging current vector. Said generating a prediction signal for the current transformer saturation comprises: generating the prediction signal for the current transformer saturation when the first current and the second current satisfy basic saturation judgment conditions and at least one of additional saturation judgment conditions, wherein the basic saturation judgment conditions comprise at least one of: a ratio of the first DC component to the first total RMS is greater than a DC ratio threshold, and a current vector angle difference which is an angle difference between the leading current vector and the lagging current vector is within a predetermined angle difference range; and a ratio of the second DC component to the second total RMS is greater than the DC ratio threshold and the current vector angle difference is within the predetermined angle difference range.

Optionally, in the method for predicting the current transformer saturation, the additional saturation judgment conditions comprise at least one of: a RMS of the leading current vector is smaller as the saturation is deeper; the current vector angle difference is greater as the saturation is deeper; a direct current component of a differential current being a difference between the first current and the second current is greater as the saturation is deeper; a same-time correlation coefficient of the first current and the second current is greater than a first predetermined threshold; and a cycle correlation coefficient of the first current and the second current is greater than a second predetermined threshold.

Optionally, in the method for predicting the current transformer saturation, the RMS of the leading current vector is smaller as the saturation is deeper comprises at least one of: the RMS of the leading current vector at a second time is smaller than the RMS of the leading current vector at a first time by a first predetermined times; and a ratio of a difference between the RMS of the leading current vector at the first time and the RMS of the leading current vector at the second time to the RMS of the leading current vector at the first time is greater than a first predetermined ratio, wherein the first time is earlier than the second time.

Optionally, in the method for predicting the current transformer saturation, the current vector angle difference is greater as the saturation is deeper comprises at least one of: the current vector angle difference at a fourth time is greater than the current vector angle difference at a third time by a second predetermined times; and a ratio of a difference between the current vector angle difference at the fourth time and the current vector angle difference at the third time to the current vector angle difference at the third time is greater than a second predetermined ratio, wherein the third time is earlier than the fourth time.

Optionally, in the method for predicting the current transformer saturation, the direct current component of the differential current is greater as the saturation is deeper comprises at least one of: the direct current component of the differential current at a sixth time is greater than the direct current component of the differential current at a fifth time by a third predetermined times; and a ratio of a difference between the direct current component of the differential current at the sixth time and the direct current component of the differential current at the fifth time to the direct current component of the differential current at the fifth time is greater than a third predetermined ratio, wherein the fifth time is earlier than the sixth time.

Optionally, in the method for predicting the current transformer saturation, the basic saturation judgment condition may further comprise: the RMS of the leading current vector is greater than a first RMS threshold.

Optionally, in the method for predicting the current transformer saturation, the additional saturation judgment condition may further comprise at least one of: the RMS of the leading current vector is smaller than the RMS of the lagging current vector by a fourth predetermined times; and a ratio of the direct current component of the differential current which is the difference between the first current and the second current to the total RMS of the differential current is greater than a fourth predetermined ratio.

Optionally, in the method for predicting the current transformer saturation, the prediction signal for the current transformer saturation identifies a current transformer corresponding to the leading current vector, wherein the leading current vector is the one which is leading between the first fundamental vector and the second fundamental vector.

Optionally, in the method for predicting the current transformer saturation, generating a detection signal of the current transformer saturation when the direct current component of the differential current which is the difference between the first current and the second current is greater than a RMS threshold of the differential current, wherein the detection signal of the current transformer saturation identifies a current transformer corresponding to the leading current vector, and wherein the leading current vector is the one which is leading between the first fundamental vector and the second fundamental vector.

Optionally, in the method for predicting the current transformer saturation, the transformer is a three-phase transformer, and each phase comprises the first current transformer and the second current transformer corresponding to the phase.

With the method for predicting the current transformer saturation according to the embodiments of the present disclosure, it may predict a case of the current transformer saturation effectively by performing a current transformer saturation prediction and detection according to variation characteristics under a sympathetic inrush of a current at a high voltage side and a current at a low voltage side output from the current transformers disposed on the high voltage side and the low voltage side of a transformer, respectively, so that a differential protection of the transformer triggered by the current transformer saturation can be avoided and a differential protection mal-operation of the transformer is prevented from occurring, which may increase a reliability in operation of the power system.

BRIEF DESCRIPTION OF THE DRAWINGS

The above and other objects, features and advantages of present disclosure will become more apparent from the detailed description given hereinafter in connection with the accompanying drawings, in which:

Fig.1 is a flowchart illustrating a method for predicting a current transformer saturation according to embodiments of the present disclosure;

Fig.2 is a diagram schematically illustrating an exemplary implementation of the method for predicting the current transformer saturation according to the embodiments of the present disclosure;

Fig.3 is a diagram schematically illustrating an implementation of a basic saturation judgment condition according to the embodiments of the present disclosure;

Fig.4 is a diagram schematically illustrating an exemplary implementation of an additional saturation judgment condition 1 according to the embodiments of the present disclosure;

Fig.5 is a diagram schematically illustrating an exemplary implementation of an additional saturation judgment condition 2 according to the embodiments of the present disclosure;

Fig.6 is a diagram schematically illustrating an exemplary implementation of an additional saturation judgment condition 3 according to the embodiments of the present disclosure;

Fig.7 is a diagram schematically illustrating an exemplary implementation of an additional saturation judgment condition 4 according to the embodiments of the present disclosure;

Fig.8 is a diagram schematically illustrating an exemplary implementation of the method for predicting the current transformer saturation according to the embodiments of the present disclosure;

Fig.9A is a diagram schematically illustrating a current transformer at a high voltage side and a current transformer at a low voltage side connected to the high voltage side and the low voltage side of a transformer in a single-phase system, respectively, in a case of an normal operation state of the transformer;

Fig.9B is a diagram schematically illustrating a current transformer at a high voltage side and a current transformer at a low voltage side connected to the high voltage side and the low voltage side of the transformer in a single-phase system, respectively, in a case of a fault operation state of the transformer; and

Fig.10 is a diagram schematically illustrating current transformers at a high voltage side and current transformers at a low voltage side connected to the high voltage side and the low voltage side of the transformer in a three-phase system, respectively.

DETAILED DESCRIPTION

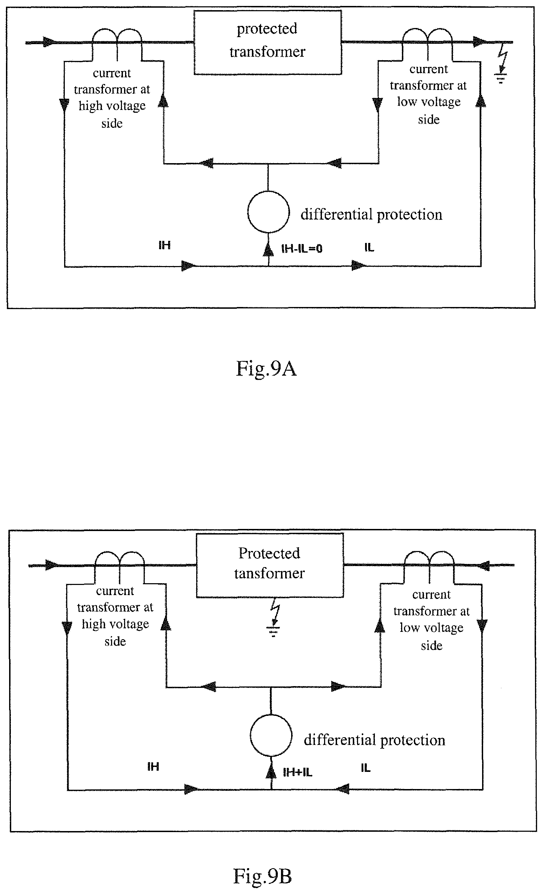

Firstly, a differential protection of a transformer will be described briefly in connection with Figs. 9A and 9B. As illustrated in Fig.9A, a current transformer for a high voltage side (hereinafter, referred to as a first current transformer) and a current transformer for a low voltage side (hereinafter, referred to as a second current transformer) are connected to the high voltage side and the low voltage side of the transformer, respectively, and the first current transformer and the second current transformer are used for the differential protection of the transformer. In particular, a current output from the current transformer at the high voltage side and a current output from the current transformer at the low voltage side are detected, and the differential protection of the transformer is trigged when a magnitude of a differential current between these two currents output from the current transformers at the high voltage side and at the low voltage side respectively exceeds a certain value, as illustrated in Fig.9B. However, as described in the "BACKGROUD" of the present specification, in a case that a sympathetic inrush occurs in a power system, a longtime sympathetic inrush may cause a saturation of the current transformer at the high voltage side or a saturation of the current transformer at the low voltage side. As the saturation deepens continually, the magnitude and an angle of the differential current between the current output from the current transformer at the high voltage side and the current output from the current transformer at the low voltage side increase continually too, and the differential protection of the transformer would be trigged when the differential current exceeds a certain extent. In this case, the differential protection is trigged by the saturation of the current transformer(s) being a detecting sensor rather than a fault in the transformer itself, therefore such differential protection of the transformer belongs to a differential protection mal-operation for the transformer and should be identified and avoided.

In view of this, inventers propose a method capable of effectively predicting whether the current transformers at both sides of the transformer are possible to be saturated based on the detected current output from the current transformer at the high voltage side and the detected current output from the current transformer at the low voltage side.

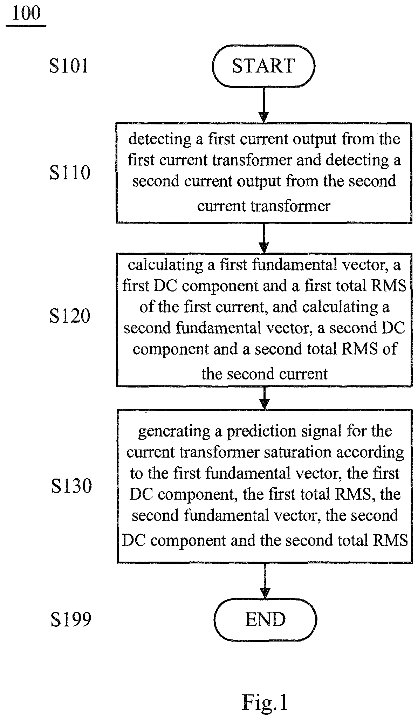

A method 100 for predicting a current transformer saturation according to embodiments of the present disclosure will be described with reference to Fig.1. As described above, a first current transformer is connected to a high voltage side of a transformer and a second current transformer is connected to a low voltage side of the transformer, the first current transformer and the second current transformer are used for a differential protection of the transformer.

The method 100 for predicting the current transformer saturation according to the embodiments of the present disclosure starts from a step S101.

At a step S110, a first current i1 output from the first current transformer and a second current i2 output from the second current transformer are detected.

At a step S120, a first fundamental vector I1, a first Direct Current (DC) component I1dc and a first total Root Mean Square (RMS) I1rms of the first current are calculated, and a second fundamental vector I2, a second DC component I2dc and a second total Root Mean Square (RMS) I2rms are calculated. It should understand that the term of "total Root Mean Square" herein represents a total RMS calculated according to detected instantaneous current values, which may comprise a fundamental component, a DC component and all of other harmonic components of the detected current.

At a step S130, a prediction signal for the current transformer saturation is generated according to the first fundamental vector I1, the first DC component I1dc, the first total RMS I1rms the second fundamental vector I2, the second DC component I2dc and the second total RMS I2rms.

At last, the method 100 for predicting the current transformer saturation ends at the step S 199.

Since implementations of the above steps S110 and S120 are well known in the art, details are omitted herein.

A detailed implementation of the step S130 in the method 100 for predicting the current transformer saturation according to the embodiments of the present disclosure will be further described in connection with drawings.

As described previously, when the current transformer at the high voltage side or the current transformer at the low voltage side is saturated because of an existence of the sympathetic inrush, the one which is saturated in the two current transformers is referred to as a saturated current transformer, and the other one is referred to as a normal current transformer.

In an ideal case, the first current output from the current transformer at the high voltage side would have a phase being consistent with a phase of the second current output from the current transformer at the low voltage side, and a normalized magnitude of the first current would be consistent with that of the second current. However, in an actual application, various factors in the power system may cause inconsistency in the phase and/or magnitude, and the power system is protected by trigging the differential protection of the transformer when the inconsistency exceeds a certain extent.

Before describing the step S130 concretely, several phenomena or criterions existing in the differential protection of the transformer are discussed firstly. It should be noted that both of the first current output from the current transformer at the high voltage side and the second current output from the current transformer at the low voltage side are subject to a normalization transformation, so the magnitudes of the first current and the second current may be compared with each other directly.

1. Basic Requirements

In a case that the sympathetic inrush occurs in the power system, the sympathetic inrush occurs on at least one side of the high voltage side and the low voltage side of the transformer, a DC component exists in the current output from the current transformer at the side where the sympathetic inrush occurs accordingly, and a proportion of the DC component in the current output from the current transformer at that side should exceed a predetermined proportion.

A current vector of the current output from the current transformer at the side where the sympathetic inrush occurs leads a current vector of the current output from the current transformer at the other side when the current transformer at the side where the sympathetic inrush occurs is saturated, and a leading angle may be within a predetermined angle difference range. The predetermined angle difference range may ensure that the current transformer has been saturated to a certain extent while the current transformer has not been saturated completely or deeply yet.

2. Magnitude Criterion

Regarding a case in which one of the current transformer at the high voltage side and the current transformer at the low voltage side is saturated, a fundamental RMS of the current output from the saturated current transformer is smaller than a fundamental RMS of the current output from the normal current transformer, and as the saturation of the saturated current transformer deepens, the fundamental RMS of the current output from the saturated current transformer decreases continually, and the fundamental RMS of the current output from the seriously saturated current transformer would be lower than the fundamental RMS of the current output from the slightly saturated current transformer.

3. Angle Criterion

For the current transformer at the high voltage side and the current transformer at the low voltage side, a fundamental angle of the current output from the saturated current transformer leads a fundamental angle of the current output from the normal current transformer, and a difference between a fundamental vector of the current output from the saturated current transformer and a fundamental vector of the current output from the normal current transformer is as a differential current. As the saturation of the saturated current transformer deepens, a differential angle of the differential current increases continually, that is, the differential angle of the differential current is greater as the saturation of the saturated current transformer is deeper.

## 4. DC Component Criterion

When the current transformer at the high voltage side or the current transformer at the low voltage side enters to a saturation state, the DC component emerges gradually in the differential current, and the DC component in the differential current may increase gradually with the deepening of the saturation of the saturated current transformer. However, a ratio of the DC component in the differential current to a total RMS of the differential current may vary slightly as the saturation of the saturated differential current deepens.

## 5. Deviation Criterion

In a case in which neither the current transformer at the high voltage side nor the current transformer at the low voltage side is saturated, the differential current between the first current output from the current transformer at the high voltage side and the second current output from the current transformer at the low voltage side is very small, and the first current and the second current has a high correlation.

However, in a case that any one of the current transformers is saturated, the differential current between the first current and the second current becomes great, and the correlation between the first current and the second current becomes poor.

The prediction for the current transformer saturation is made based on the above basic requirements and various other criterions. It should be understood that the above basic requirements are basic necessary conditions for the current transformer saturation. Besides these, at least one criterions described above may be utilized to avoid errors in the saturation prediction, and may further ensure an accuracy of the saturation prediction.

In particular, in the method for predicting the current transformer saturation according to the embodiments of the present disclosure, in the steps S120 or S130, the fundamental vector whose phase leads between the first fundamental vector and the second fundamental vector is detected as a leading current vector, and the other one is called as a lagging current vector. The leading current vector actually corresponds to the current output from the current transformer which may be saturated, while the lagging current vector actually corresponds to the current output from the normal current transformer.

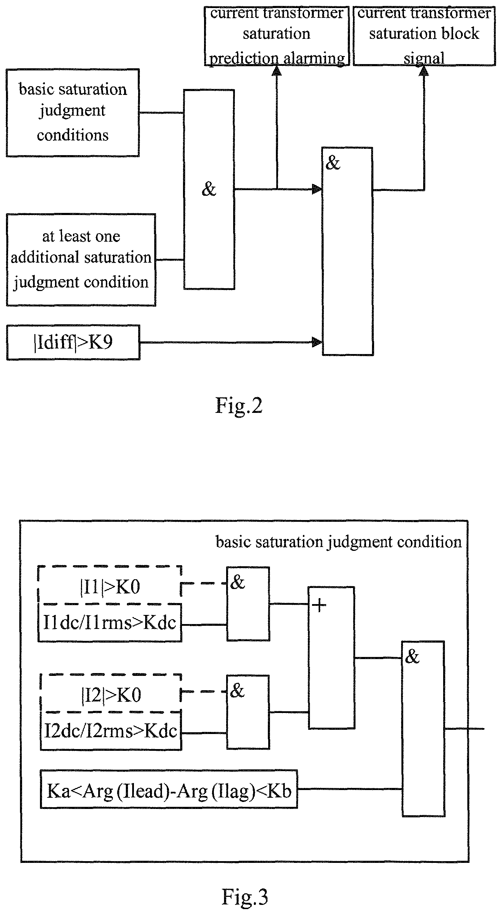

Next, in the step S130, the prediction signal for the current transformer saturation is generated when the first current and the second current satisfy basic saturation judgment conditions and at least one of additional saturation judgment conditions. Fig.2 also illustrates an exemplary implementation of the step S130, wherein a current transformer saturation prediction alarming module generates a current transformer saturation prediction alarm signal or a current transformer saturation prediction signal when it receives an input signal in a high level, and a current transformer saturation blocking signal is used for blocking the differential protection.

As described previously, the basic saturation judgment conditions are set in accordance with the basic requirements, therefore the basic saturation judgment conditions may comprise at least one of: a ratio of the first DC component to the first total RMS is greater than a DC ratio threshold, and a current vector angle difference which is an angle difference between the leading current vector and the lagging current vector is within a predetermined angle difference range; and a ratio of the second DC component to the second total RMS is greater than the DC ratio threshold and the current vector angle difference is within the predetermined angle difference range.

In an example, in a case in which the current transformer at the high voltage side is saturated while the current transformer at the low voltage side is normal, the ratio of the first DC component I1dc to the first total RMS I1rms is greater than a DC ratio threshold Kdc, and the current vector angle difference which is the angle difference between the first fundamental vector (that is, the leading current vector) and the second fundamental vector (that is, the lagging current vector) is within the predetermined angle difference range.

In another example, in a case in which the current transformer at the high voltage side is normal while the current transformer at the low voltage side is saturated, the ratio of the second DC component I2dc to the second total RMS I2rms is greater than the DC ratio threshold Kdc, and the current vector angle difference which is the angle difference between the second fundamental vector (that is, the leading current vector) and the first fundamental vector (that is, the lagging current vector) is within the predetermined angle difference range.

Further, other basic conditions may be incorporated in the basic saturation judgment conditions in order to make the basic saturation judgment conditions be stricter, that is, to make the prediction of the current transformer saturation be more accurate accordingly.

For example, the basic saturation judgment conditions may comprise at least one of: a magnitude of the first fundamental vector I1 is greater than a predetermined magnitude threshold, a ratio of the first DC component to the first total RMS is greater than a DC ratio threshold, and a current vector angle difference which is an angle difference between the leading current vector and the lagging current vector is within a predetermined angle difference range; and a magnitude of the second fundamental vector I2 is greater than the predetermined magnitude threshold, a ratio of the second DC component to the second total RMS is greater than the DC ratio threshold and the current vector angle difference is within the predetermined angle difference range.

In this case, in an example, in a case in which the current transformer at the high voltage side is saturated while the current transformer at the low voltage side is normal, the magnitude $|I1|$ of the first fundamental vector I1 is greater than the predetermined magnitude threshold K0, the ratio of the first DC component I1dc to the first total RMS I1rms is greater than a DC ratio threshold Kdc, and the current vector angle difference which is the angle difference between the first fundamental vector (that is, the leading current vector) and the second fundamental vector (that is, the lagging current vector) is within the predetermined angle difference range.

In another example, in a case in which the current transformer at the high voltage side is normal while the current transformer at the low voltage side is saturated, the magnitude $|I2|$ of the second fundamental vector I2 is greater than the predetermined magnitude threshold K0, the ratio of the second DC component I2dc to the second total RMS I2rms is greater than the DC ratio threshold Kdc, and the current vector angle difference which is the angle difference between the second fundamental vector (that is, the leading current vector) and the first fundamental vector (that is, the lagging current vector) is within the predetermined angle difference range.

Fig.3 illustrates judgment situations for the basic saturation judgment conditions, wherein portions with dot lines denote optional items and portions with solid lines denote affirmatively chosen items, and wherein "&" denotes a logic "AND" operation, "+" denote a logic "OR" operation.

In Fig.3, $|I1|$ represents the magnitude of the first fundamental vector I1, $|I2|$ represents the magnitude of the second fundamental vector I2, I1dc represents the first DC component, I1rms represents the first total RMS, I2dc represents the second DC component, I2rms represents the second total RMS, Ilead represents the leading current vector, and the Ilag represents the lagging current vector. For example, in a case that the first fundamental vector I1 leads the second fundamental vector I2, Ilead=I1 and Ilag=I2, otherwise in a case that the second fundamental vector I2 leads the first fundamental vector I1, Ilead=I2 and Ilag=I1. K0 represents the predetermined magnitude threshold, Kdc represents the predetermined DC ratio threshold, Ka represents a lower limit of the predetermined angle difference range, and Kb represents an upper limit of the predetermined angle difference range.

As an example, the above parameters may be as follows: K0=0.1, Kdc=0.1, Ka=0.2, Kb=1.0. Obviously, the present disclosure is not limited thereto and those skilled in the art may set other values depending on actual applications.

The additional saturation judgment conditions may be designed according to the various criterions described above, therefore the additional saturation judgment conditions may comprise at least one of: a RMS of the leading current vector is smaller as the saturation is deeper (the Magnitude Criterion); the current vector angle difference is greater as the saturation is deeper (the Angle Criterion); a direct current component of a differential current being a difference between the first current and the second current is greater as the saturation is deeper (the DC Component Criterion); a same-time correlation coefficient of the first current and the second current is greater than a first predetermined threshold (the Deviation Criterion); and a cycle correlation coefficient of the first current and the second current is greater than a second predetermined threshold (the Deviation Criterion).

The additional saturation judgment conditions would be discussed below one by one.

Regarding the Magnitude Criterion, just as stated previously, with a deepening of the saturation of the saturated current transformer, the fundamental RMS of the current output from the saturated current transformer decreases continually, the fundamental RMS of the current output from the seriously saturated current transformer would be lower than the fundamental RMS of the current output from the slightly saturated current transformer, and a speed at which the fundamental RMS decreases is greater than a predetermined speed.

In an example, in a case that the current transformer at the high voltage side is saturated, the magnitude $|I1|$ (that is, the fundamental RMS) of the first fundamental vector I1 of the first current output from the current transformer at the high voltage side decreases continually with lapse of time when the saturation of the current transformer at the high voltage side deepens with the lapse of time, and the speed at which the magnitude decreases is greater than the predetermined speed.

For example, the first current is sampled at a predetermined interval (that is, at a predetermined sampling period), and the first fundamental vector I1 of the first current is calculated at each sampling time accordingly. The first fundamental vector I1(t1) is calculated at a first sampling time, and the first fundamental vector I1(t2) is calculated at a second sampling time thereafter, wherein at least one the predetermined interval (that is, the predetermined sampling period) is included between the first sampling time and the second sampling time. The magnitude (that is, the Root Mean Square) of the first fundamental vector I1(t2) is smaller than the magnitude (that is, the Root Mean Square) of the first fundamental vector I1(t1) by a first predetermined times K2, or a ratio of a difference between the magnitude of the first fundamental vector I1(t2) and the magnitude of the first fundamental vector I1(t1) to the magnitude of the first fundamental vector I1(t1) is greater than a first predetermined ratio K2'.

In another example, in a case that the current transformer at the low voltage side is saturated, the additional saturation judgment conditions may be set similarly.

For example, the second fundamental vector I2(t1) is calculated at the first sampling time, and the second fundamental vector I2(t2) is calculated at the second sampling time thereafter, wherein at least one the predetermined interval (that is, the predetermined sampling period) is included between the first sampling time and the second sampling time. The magnitude (that is, the Root Mean Square) of the second fundamental vector I2(t2) is smaller than the magnitude (that is, the Root Mean Square) of the second fundamental vector I2(t1) by the first predetermined times K2, or a ratio of a difference between the magnitude of the second fundamental vector I2(t2) and the magnitude of the second fundamental vector I2(t1) to the magnitude of the second fundamental vector I2(t1) is greater than a first predetermined ratio K2'.

Further, another magnitude relationship may be incorporated into the additional saturation judgment conditions, that is, the Root Mean Square (|Ilead|) of the current output from the saturated current transformer is smaller than the Root Mean Square (|Ilag|) of the current output from the normal current transformer by a fourth predetermined times K1.

In another example, this additional saturation judgment condition is judged only when an angle difference between the leading current vector Ilead and the lagging current vector Ilag is within a second predetermined angle difference range, a lower limit of the second predetermined angle difference range may be represented as a1, and an upper limit of the second predetermined angle difference range may be represented as a0, and they may satisfy a relationship herein as follows: a0 ≥ Kb > a1 ≥ Ka.

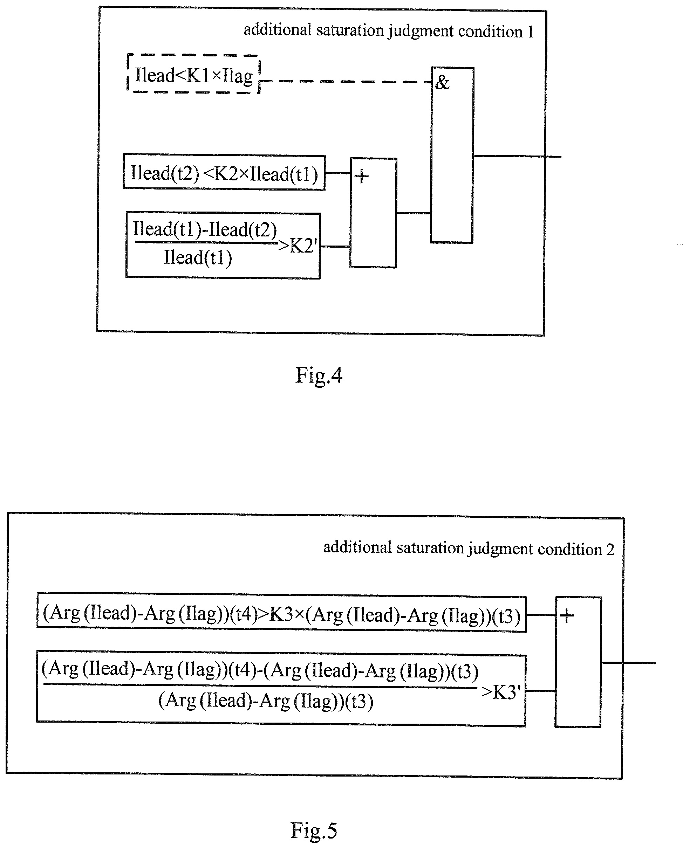

The additional saturation judgment condition is shown in Fig.4, wherein |Ilead| denotes the Root Mean Square of the leading current vector Ilead, |Ilag| denotes the Root Mean Square of the lagging current vector Ilag, and wherein a dotted box denotes an optional item, while at least one of two solid boxes below the dotted box should exist, wherein "&" denotes a logic "AND" operation, "+" denote a logic "OR" operation.

As an example, following values may be acceptable: K1=0.98, K2=0.95, a1=0.5, a0=20. Obviously, the embodiments of the present disclosure are not limited thereto and those skilled in the art may utilize other values depending on the actual situations.

Regarding the Angle Criterion, just as stated previously, with the deepening of the saturation of the saturated current transformer, a differential angle of the differential current which is a difference between the fundamental vector of the current output from the saturated current transformer and the fundamental vector of the current output from the normal current transformer increases linearly and continually, and a speed at which the differential angle increases is greater than a predetermined speed.

The first current and the second current may be sampled at a predetermined interval (that is, a predetermined sampling period), and the differential angle between the first current and the second current may be calculated at each sampling time accordingly. In particular, a differential angle (Arg(Ilead)-Arg(Ilag))(t3) is calculated at a third sampling time, and a differential angle (Arg(Ilead)-Arg(Ilag))(t4) is calculated at a fourth sampling time. The third sampling time may be or not be the first sampling time, and the fourth sampling time may be or not be the second sampling time. For example, an interval between the fourth sampling time and the third sampling time may be a fundamental cycle.

In an example, the differential angle (Arg(Ilead)-Arg(Ilag))(t4) calculated at the fourth sampling time is greater than the differential angle (Arg(Ilead)-Arg(Ilag))(t3) calculated at the third by a second predetermined times K3.

In another example, a ratio of a difference between the differential angle (Arg(Ilead)-Arg(Ilag))(t4) calculated at the fourth sampling time and the differential angle (Arg(Ilead)-Arg(Ilag))(t3) calculated at the third sampling time to the differential angle (Arg(Ilead)-Arg(Ilag))(t3) calculated at the third sampling time is greater than a second predetermined ratio K3'.

Fig.5 illustrates this additional saturation judgment condition, wherein Arg(Ilead) denotes a vector angle of the leading current vector Ilead, and Arg(Ilag) denotes a vector angle of the lagging current vector Ilag, wherein at least one of solid boxes should exist, and wherein "+" denotes the logic "OR" operation.

As an example, following value may be acceptable: K3=1.1. Obviously, the embodiments of the present disclosure are not limited thereto and those skilled in the art may utilize other values depending on the actual situations.

Regarding the DC Component Criterion, just as stated previously, the DC component in the differential current may increase gradually with the deepening of the saturation of the saturated current transformer. Therefore, the corresponding additional saturation judgment conditions of the present disclosure may be designed accordingly.

The first current and the second current may be sampled at the predetermined interval (that is, the predetermined sampling period), and a DC component in a differential current between the first current and the second current may be calculated at the each sampling time. In particular, a DC component Idiff_dc(t5) in the differential current is calculated at a fifth sampling time, and a DC component Idiff_dc(t6) in the differential current is calculated at a sixth sampling time. Time interval between the sixth sampling time and the fifth sampling time may be an integer multiple of the predetermined sampling period, for example, the sixth sampling time may later than the fifth sampling time by a time period being equal to the fundamental cycle approximately.

In an example, the DC component Idiff_dc(t6) in the differential current at the sixth sampling time is greater than the DC component Idiff_dc(t5) in the differential current at the fifth sampling time by a third predetermined times K4.

In another example, a ratio of a difference between the DC component Idiff_dc(t6) in the differential current at the sixth sampling time and the DC component Idiff_dc(t5) in the differential current at the fifth sampling time to the DC component Idiff_dc(t5) in the differential current at the fifth sampling time is greater than a third predetermined ratio K4'.

Another condition may be incorporated into this additional saturation judgment condition, the DC component in the differential current at the sixth sampling time is calculated as Idiff_dc(t6), and a total RMS of the differential current is calculated as Idiff_rms(t6), thus a ratio of the DC component Idiff_dc(t6) to the total RMS Idiff_rms(t6) at this time is greater than a fourth predetermined ratio K5.

This additional saturation judgment condition is shown in Fig.4, wherein a dotted box denotes an optional item, while at least one of two solid boxes above the dotted box should exist, wherein "&" denotes a logic "AND" operation, "+" denote a logic "OR" operation.

As an example, following values may be acceptable: K4=1.1, K5=0.2. Obviously, the embodiments of the present disclosure are not limited thereto and those skilled in the art may utilize other values depending on the actual situations.

Regarding the Deviation Criterion, in a case that any one of the current transformers is saturated, the differential current between the first current and the second current becomes great, and the correlation between the first current and the second current becomes poor. For example, the correlation comprises two kinds of correlations: a same-time correlation and a cycle correlation. In an example, the prediction is performed only when both of the two correlation conditions are satisfied, in order to improve an accuracy of the correlation prediction.

The same-time correlation and the cycle correlation will be described below by taking an example for extracting the fundamental RMS four times (extracting every 90°) during each fundamental cycle.

With respect to the sampled first current and the sampled second current, by extracting the fundamental RMS four times during each fundamental cycle, more than five fundamental RMSs of the first current, which are represented as H1, H2, H3, H4 and H5, respectively, for example, are acquired continually for the current transformer at the high voltage side; and more than five fundamental RMSs of the second current, which are represented as L1, L2, L3, L4 and L5, respectively, for example, are acquired continually for the current transformer at the low voltage side

Regarding the same-time correlation, for each of calculation times, a correlation coefficient HL11 between the H1 and L1, a correlation coefficient HL22 between the H2 and L2, and a correlation coefficient HL33 between the H3 and L3 may be calculated as follows. Greater the correlation coefficient is, greater a difference between the fundamental RMS of the first current and the fundamental RMS of the second current at the corresponding calculation time is, greater the correlation coefficient is, poorer the correlation (similarity) is.

$$HL11=|H1-L1|/min(H1,L1)$$

$$HL22=|H2-L2|/min(H2,L2)$$

$$HL33=|H3-L3|/min(H3,L3)$$

Wherein min() denotes a minimization.

Next, a maximum among the correlation coefficients HL11, HL22 and HL33 calculated above may be acquired, that is, a maximum correlation coefficient HLMAX=max(HHL11,HL22,HL33).

Regarding the cycle correlation, same-side correlation coefficients H13, H24 and H35 may be calculated for the first current, while same-side correlation coefficients L13, L24 and L35 may be calculated for the second current.

$$H13=(H1-H3)/min(H1,H3)$$

$$H24=(H2-H4)/min(H2,H4)$$

$$H35=(H3-H5)/min(H3,H5)$$

$$L13=(L1-L3)/min(L1,L3)$$

$$L24=(L2-L4)/min(L2,L4)$$

$$L35=(L3-L5)/min(L3,L5)$$

Regarding the H13 and L13, if both of absolute values of the H13 and L13 are greater than a first same-side correlation threshold, or signs of the H13 and L13 are opposite and both of the absolute values of the H13 and L13 are greater than a second same-side correlation threshold, a both-side correlation coefficient may be calculated as follows: HL13=|H13-L13|/max(H13,L13), wherein the second same-side correlation threshold is smaller than the first same-side correlation threshold, and for example following values may be acceptable, the first same-side correlation threshold is equal to 0.15 while the second same-side correlation threshold is equal to 0.02. It is not needed to calculate the HL13 if the above conditions are not satisfied, that is, the HL 13 is invalid.

Regarding the H24 and L24, if both of absolute values of the H24 and L24 are greater than the first same-side correlation threshold, or signs of the H24 and L24 are opposite and both of the absolute values of the H24 and L24 are greater than the second same-side correlation threshold, a both-side correlation coefficient may be calculated as follows similarly: HL24=|H24-L24|/max(H24,L24). It is not needed to calculate the HL24 if the above conditions are not satisfied, that is, the HL24 is invalid.

Regarding the H35 and L35, if both of absolute values of the H35 and L35 are greater than the first same-side correlation threshold, or signs of the H35 and L35 are opposite and both of the absolute values of the H35 and L35 are greater than the second same-side correlation threshold, a both-side correlation coefficient may be calculated as follows similarly: HL35=|H35-L35|/max(H35,L35). It is not needed to calculate the HL35 if the above conditions are not satisfied, that is, the HL35 is invalid.

If all of the HL13, HL24 and HL35 are valid, the cycle correlation may be calculated as follows:

$$HL=(HL13+HL24+HL35)/3.$$

If only two of the HL13, HL24 and HL35 are valid (for example, the HL13 and HL35 are valid, but the HL 24 is invalid), the cycle correlation may be calculated as follows:

$$HL=(HL13+ HL35)/2.$$

It may be predicted that the current transformer saturation might occur when the calculated maximum same-time correlation coefficient HLMAX is greater than a first predetermined threshold K6 or the calculated cycle correlation HL is greater than a second predetermined threshold K7. The first predetermined threshold K6 may have a value of 0.05 for example, and the second predetermined threshold K7 may have a value of 0.20 for example. In an example, it may be predicted that the current transformer saturation might occur only when the calculated maximum same-time correlation coefficient HLMAX is greater than the first predetermined threshold K6 and the calculated cycle correlation HL is greater than the second predetermined threshold K7.

Auxiliary correlation criterions may be incorporated into either the same-time correlation or the cycle correlation, in order to make the correlation prediction being more accurate. The auxiliary correlation criterions may be: a ratio of a minimum to a maximum in two fundamental RMSs of the first current, which are calculated in two adjacent fundamental cycles and has an interval of one fundamental cycle, is greater than a fifth predetermined ratio K8. For example, the fifth predetermined ratio may have a value of 0.8.

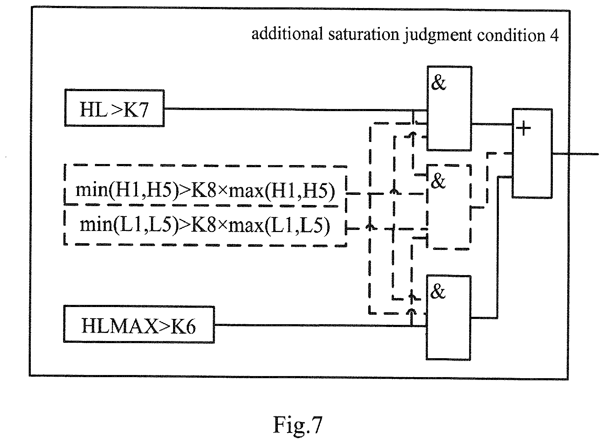

The additional saturation judgment condition of the correlation is shown in Fig.7, wherein K6 denotes the first predetermined threshold, K7 denotes the second predetermined threshold, and K8 denotes the fifth predetermined ratio.

As an example, following values may be acceptable: K6=0.2, K7=0.05, K8=0.8. Obviously, the embodiments of the present disclosure are not limited thereto and those skilled in the art may utilize other values depending on the actual situations.

Although the same-time correlation and the cycle correlation are described by taking an example for extracting the fundamental RMS four times during each of the fundamental cycle, the embodiments of the present disclosure are not limited thereto, and those skilled in the art may extract n fundamental RMSs (for example, n=6, 7, 8, etc.) during each fundamental cycle and calculate the same-time correlation and the cycle correlation using at least n+1 continuous fundamental RMSs calculated in two adjacent fundamental cycles.

In particular, in the step S130, the prediction signal for the current transformer saturation may be generated in a case that at least one of the above additional saturation judgment conditions is further satisfied under a precondition that the basic saturation judgment conditions have been satisfied, that is to say, the prediction signal for the current transformer saturation may be generated effectively before the current transformer is saturated deeply and the differential protection is trigged. For example, the prediction signal for the current transformer saturation may identify the current transformer corresponding to the leading current vector, that is, the current transformer at the high voltage side or the current transformer at the low voltage side.

Further, according to the embodiments of the present disclosure, a detection signal for the current transformer saturation may be generated and the differential protection of the transformer may be blocked when the fundamental RMS |Idiff| of the differential current is greater than a fundamental RMS threshold of the differential current. The detection signal for the current transformer saturation may identify the current transformer corresponding to the leading current vector, that is, the current transformer at the high voltage side or the current transformer at the low voltage side.

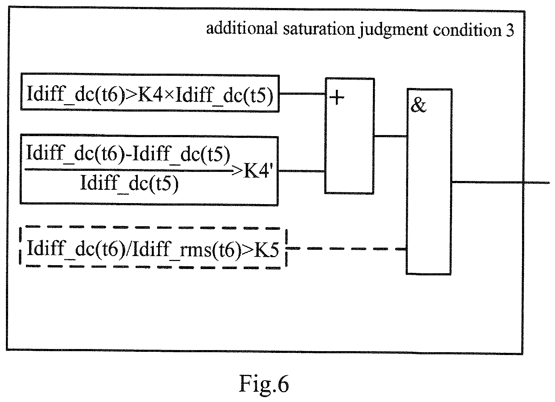

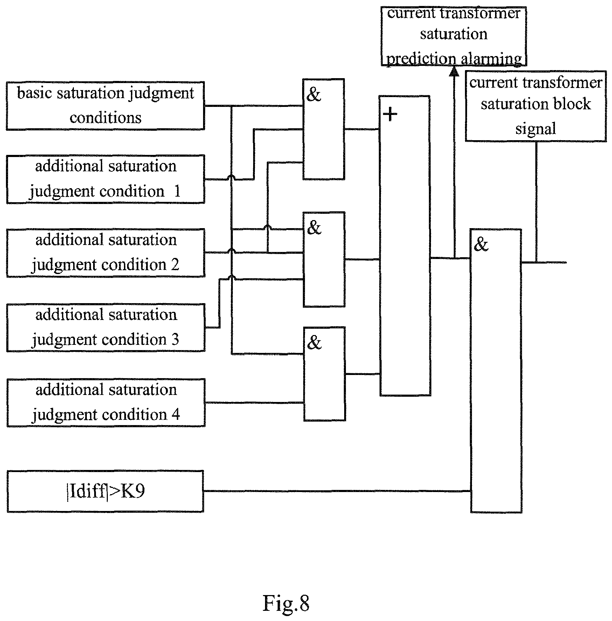

Fig.8 schematically illustrates an exemplary implementation of the method for predicting the current transformer saturation according to the embodiments of the present disclosure. The implementation may be well understood with reference to Fig.2-Fig.7, so details are omitted herein.

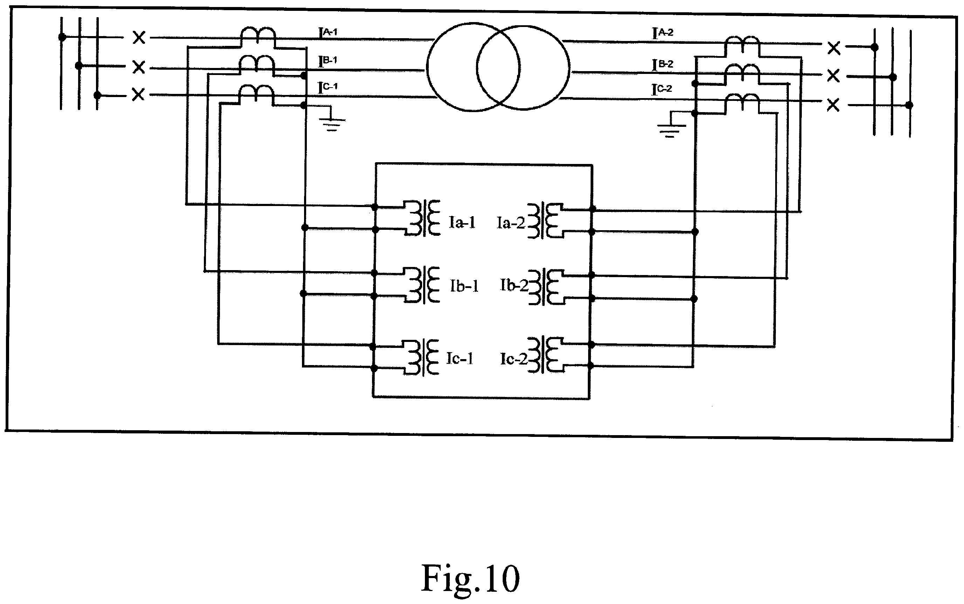

The method for predicting the current transformer saturation according to the embodiments of the present disclosure is described by taking the single-phase system as an example as above. However, it should understand that the embodiments of the present disclosure are not limited thereto, and the method for predicting the current transformer saturation according to the embodiments of the present disclosure may be applied to a three-phase system easily, for example, the method for predicting the current transformer saturation according to the embodiments of the present disclosure may be applied to each phase in the three-phase system, respectively, as illustrated in Fig.10.

With the method for predicting the current transformer saturation according to the embodiments of the present disclosure, it may predict the current transformer saturation effectively by performing a current transformer saturation prediction and detection according to variation characteristics of a current at a high voltage side and a current at a low voltage side output from the current transformers disposed on the high voltage side and the low voltage side of a transformer, respectively, in a case of a sympathetic inrush, so that a differential protection of the transformer triggered by the current transformer saturation can be avoided and a differential protection maloperation of the transformer can be prevented from occurring, which may increase a reliability in operation of the power system.

The above descriptions only illustrate the specific embodiments of the present invention, and the protection scope of the present invention is not limited to this. Given the teaching as disclosed herein, variations or substitutions, which can easily occur to any skilled pertaining to the art, should be covered by the protection scope of the present invention. Thus, the protection scope of the present invention is defined by the claims.

**Claims**

1. A method for predicting a current transformer saturation, wherein a first current transformer is connected to a high voltage side of a transformer and a second current transformer is connected to a low voltage side of the transformer, the first current transformer and the second current transformer are used for a differential protection of the transformer, the method for predicting the current transformer saturation comprises:

   detecting (S110) a first current which is output from the first current transformer and detecting a second current which is output from the second current transformer;
   calculating (S120) a first fundamental vector, a first Direct Current component, first DC component, and a first total Root Mean Square (RMS) of the first current, and calculating a second fundamental vector, a second DC component and a second total Root Mean Square of the second current; and
   **characterized in that** the method further comprises:

   generating (130) a prediction signal for the current transformer saturation according to the first fundamental vector, the first DC component, the first total Root Mean Square, the second fundamental vector, the second DC component and the second total Root Mean Square,
wherein one of the first fundamental vector and the second fundamental vector whose phase leads is a leading current vector, and the other is a lagging current vector,
wherein the generating a prediction signal for the current transformer saturation comprises: generating the prediction signal for the current transformer saturation when the first current and the second current satisfy basic saturation judgment conditions and at least one of additional saturation judgment conditions,
wherein the basic saturation judgment condition comprises at least one of:

   a ratio of the first DC component to the first total Root Mean Square is greater than a DC ratio threshold, and a current vector angle difference which is an angle difference between the leading current vector and the lagging current vector is within a predetermined angle difference range; and
   a ratio of the second DC component to the second total Root Mean Square is greater than the DC ratio threshold, and the current vector angle difference is within the predetermined angle difference range.

2. The method for predicting a current transformer saturation of claim 1, wherein the additional saturation judgment conditions comprise at least one of:

   a Root Mean Square of the leading current vector decreases;
   the current vector angle difference increases;
   a direct current component of a differential current being a difference between the first current and the second current increases;
   a same-time correlation coefficient of the first current and the second current is greater than a first predetermined threshold; and
   a cycle correlation coefficient of the first current and the second current is greater than a second predetermined threshold.

3. The method for predicting a current transformer saturation of claim 2, wherein the Root Mean Square of the leading current vector decreases comprises at least one of:

   the Root Mean Square of the leading current vector at a second time is smaller than a product of the Root Mean Square of the leading current vector at a first time and a first predetermined times; and

a ratio of a difference between the Root Mean Square of the leading current vector at the first time and the Root Mean Square of the leading current vector at the second time to the Root Mean Square of the leading current vector at the first time is greater than a first predetermined ratio,

wherein the first time is earlier than the second time.

4. The method for predicting a current transformer saturation of claim 2, wherein the current vector angle difference increases comprises at least one of:

the current vector angle difference at a fourth time is greater than a product of the current vector angle difference at a third time and a second predetermined times; and
a ratio of a difference between the current vector angle difference at the fourth time and the current vector angle difference at the third time to the current vector angle difference at the third time is greater than a second predetermined ratio,

wherein the third time is earlier than the fourth time.

5. The method for predicting a current transformer saturation of claim 2, wherein the direct current component of the differential current increases comprises at least one of:

the direct current component of the differential current at a sixth time is greater than a product of the direct current component of the differential current at a fifth time and a third predetermined times; and
a ratio of a difference between the direct current component of the differential current at the sixth time and the direct current component of the differential current at the fifth time to the direct current component of the differential current at the fifth time is greater than a third predetermined ratio,

wherein the fifth time is earlier than the sixth time.

6. The method for predicting a current transformer saturation of claim 1, wherein the basic saturation judgment conditions further comprise: the Root Mean Square of the leading current vector is greater than a first Root Mean Square threshold.

7. The method for predicting a current transformer saturation of claim 2, wherein the additional saturation judgment conditions further comprise at least one of:

the Root Mean Square of the leading current vector is smaller than a product of the Root Mean Square of the lagging current vector and a fourth predetermined times; and
a ratio of the direct current component of the differential current which is the difference between the first current and the second current to the total Root Mean Square of the differential current is greater than a fourth predetermined ratio.

8. The method for predicting a current transformer saturation of claim 1, wherein the prediction signal for the current transformer saturation identifies a current transformer corresponding to the leading current vector.

9. The method for predicting a current transformer saturation of any one of claims 1-8, wherein the transformer is a three-phase transformer, and each phase comprises the first current transformer and the second current transformer corresponding to the phase.

10. The method for predicting a current transformer saturation of any one of claims 1-8, wherein a sympathetic inrush flows through the transformer.

**Patentansprüche**

1. Verfahren zum Vorhersagen einer Stromwandlersättigung, wobei ein erster Stromwandler mit einer Hochspannungsseite eines Transformators verbunden ist und ein zweiter Stromwandler mit einer Niederspannungsseite des Transformators verbunden ist, der erste Stromwandler und der zweite Stromwandler für einen differentiellen Schutz des Transformators verwendet werden, wobei das Verfahren zum Vorhersagen der Stromwandlersättigung umfasst, dass:

ein erster Strom detektiert wird (S110), der von dem ersten Stromwandler ausgegeben wird, und ein zweiter Strom detektiert wird, der von dem zweiten Stromwandler ausgegeben wird;
ein erster Grundvektor, eine erste Gleichstromkomponente, erste DC-Komponente, und ein erster gesamter quadratischer Mittelwert (RMS) des ersten Stroms berechnet werden (S120), und ein zweiter Grundvektor, eine zweite DC-Komponente und ein zweiter gesamter quadratischer Mittelwert des zweiten Stroms berechnet werden; und
**dadurch gekennzeichnet, dass** das Verfahren ferner umfasst, dass:

ein Vorhersagesignal für die Stromwandlersättigung gemäß dem ersten Grundvektor, der ersten DC-Komponente, dem ersten gesamten quadratischen Mittelwert, dem zweiten Grundvektor, der zweiten DC-Komponente und dem zweiten gesamten quadratischen Mittelwert erzeugt wird (130), wobei entweder der erste Grundvektor oder der zweite Grundvektor, dessen Phase voreilt, ein voreilender Stromvektor ist und der andere ein nacheilender Stromvektor ist, wobei das Erzeugen eines Vorhersagesignals für die Stromwandlersättigung umfasst, dass: das Vorhersagesignal für die Stromwandlersättigung erzeugt wird, wenn der erste Strom und der zweite Strom grundlegende Sättigungsbeurteilungsbedingungen und mindestens eine von zusätzlichen Sättigungsbeurteilungsbedingungen erfüllen,

wobei die grundlegende Sättigungsbeurteilungsbedingung umfasst:

ein Verhältnis der ersten DC-Komponente zu dem ersten gesamten quadratischen Mittelwert ist größer als ein DC-Verhältnis-Schwellenwert, und eine Stromvektorwinkeldifferenz, die eine Winkeldifferenz zwischen dem voreilenden Stromvektor und dem nacheilenden Stromvektor ist, liegt innerhalb eines vorbestimmten Winkeldifferenzbereichs; und/oder
ein Verhältnis der zweiten DC-Komponente zu dem zweiten gesamten quadratischen Mittelwert ist größer als der DC-Verhältnis-Schwellenwert, und die Stromvektorwinkeldifferenz liegt innerhalb des vorbestimmten Winkeldifferenzbereichs.

2. Verfahren zum Vorhersagen einer Stromwandlersättigung nach Anspruch 1, wobei die zusätzlichen Sättigungsbeurteilungsbedingungen umfassen:

ein quadratischer Mittelwert des voreilenden Stromvektors nimmt ab; und/oder
die Stromvektorwinkeldifferenz nimmt zu; und/oder
eine Gleichstromkomponente eines Differenzstroms, der eine Differenz zwischen dem ersten Strom und dem zweiten Strom ist, nimmt zu; und/oder
ein Gleichzeitigkeits-Korrelationskoeffizient des ersten Stroms und des zweiten Stroms ist größer als ein erster vorbestimmter Schwellenwert; und/oder
ein Zykluskorrelationskoeffizient des ersten Stroms und des zweiten Stroms ist größer als ein zweiter vorbestimmter Schwellenwert.

3. Verfahren zum Vorhersagen einer Stromwandlersättigung nach Anspruch 2, wobei das Merkmal, dass der quadratische Mittelwert des voreilenden Stromvektors abnimmt, umfasst:

der quadratische Mittelwert des voreilenden Stromvektors zu einem zweiten Zeitpunkt ist kleiner als ein Produkt aus dem quadratischen Mittelwert des voreilenden Stromvektors zu einem ersten Zeitpunkt und einem ersten vorbestimmten Faktor; und/oder
ein Verhältnis einer Differenz zwischen dem quadratischen Mittelwert des voreilenden Stromvektors zu dem ersten Zeitpunkt und dem quadratischen Mittelwert des voreilenden Stromvektors zu dem zweiten Zeitpunkt zu dem quadratischen Mittelwert des voreilenden Stromvektors zu dem ersten Zeitpunkt ist größer als ein erstes vorbestimmtes Verhältnis,
wobei der erste Zeitpunkt zeitlich vor dem zweiten Zeitpunkt liegt.

4. Verfahren zum Vorhersagen einer Stromwandlersättigung nach Anspruch 2, wobei das Merkmal, dass die Stromvektorwinkeldifferenz zunimmt, umfasst:

die Stromvektorwinkeldifferenz zu einem vierten Zeitpunkt ist größer als ein Produkt aus der Stromvektorwinkeldifferenz zu einem dritten Zeitpunkt und einem zweiten vorbestimmten Faktor; und/oder
ein Verhältnis einer Differenz zwischen der Stromvektorwinkeldifferenz zu dem vierten Zeitpunkt und der Stromvektorwinkeldifferenz zu dem dritten Zeitpunkt zu der Stromvektorwinkeldifferenz zu dem dritten Zeitpunkt ist größer als ein zweites vorbestimmtes Verhältnis,
wobei der dritte Zeitpunkt zeitlich vor dem vierten Zeitpunkt liegt.

5. Verfahren zum Vorhersagen einer Stromwandlersättigung nach Anspruch 2, wobei das Merkmal, dass die Gleichstromkomponente des Differenzstroms zunimmt, umfasst:

die Gleichstromkomponente des Differenzstroms zu einem sechsten Zeitpunkt ist größer als ein Produkt aus der Gleichstromkomponente des Differenzstroms zu einem fünften Zeitpunkt und einem dritten vorbestimmten Faktor; und/oder
ein Verhältnis einer Differenz zwischen der Gleichstromkomponente des Differenzstroms zu dem sechsten Zeitpunkt und der Gleichstromkomponente des Differenzstroms zu dem fünften Zeitpunkt zu der Gleichstromkomponente des Differenzstroms zu dem fünften Zeitpunkt ist größer als ein drittes vorbestimmtes Verhältnis,

wobei der fünfte Zeitpunkt zeitlich vor dem sechsten Zeitpunkt liegt.

6. Verfahren zum Vorhersagen einer Stromwandlersättigung nach Anspruch 1, wobei die grundlegenden Sättigungsbeurteilungsbedingungen ferner umfassen: der quadratische Mittelwert des voreilenden Stromvektors ist größer als ein ersten Schwellenwert des quadratischen Mittelwerts.

7. Verfahren zum Vorhersagen einer Stromwandlersättigung nach Anspruch 2, wobei die zusätzlichen Sättigungsbeurteilungsbedingungen ferner umfassen:

der quadratische Mittelwert des voreilenden Stromvektors ist kleiner als ein Produkt aus dem quadratischen Mittelwert des nacheilenden Stromvektors und einer vierten vorbestimmten Zeit; und/oder
ein Verhältnis der Gleichstromkomponente des Differenzstroms, welcher die Differenz zwischen dem ersten Strom und dem zweiten Strom ist, zu dem gesamten quadratischen Mittelwert des Differenzstroms ist größer als ein viertes vorbestimmtes Verhältnis.

8. Verfahren zum Vorhersagen einer Stromwandlersättigung nach Anspruch 1, wobei das Vorhersagesignal für die Stromwandlersättigung einen Stromwandler identifiziert, der dem voreilenden Stromvektor entspricht.

9. Verfahren zum Vorhersagen einer Stromwandlersättigung nach einem der Ansprüche 1 - 8, wobei der Transformator ein Dreiphasentransformator ist und jede Phase entsprechend den ersten Stromwandler und den zweiten Stromwandler für jede Phase umfasst.

10. Verfahren zum Vorhersagen einer Stromwandlersättigung nach einem der Ansprüche 1 - 8, wobei ein synchronisierter Einschaltstrom durch den Transformator hindurchfließt.

**Revendications**

1. Procédé pour prédire une saturation d'un transformateur de courant, dans lequel un premier transformateur de courant est connecté à un côté haute tension d'un transformateur et un second transformateur de courant est connecté à un côté basse tension du transformateur, le premier transformateur de courant et le second transformateur de courant sont utilisés pour une protection différentielle du transformateur, le procédé pour prédire la saturation du transformateur de courant comprend les étapes consistant à :

détecter (S110) un premier courant qui est délivré depuis le premier transformateur de courant et détecter un second courant qui est délivré depuis le second transformateur de courant ;
calculer (S120) un premier vecteur fondamental, un premier composant à courant continu, et une première valeur moyenne quadratique totale du premier courant, et calculer un second vecteur fondamental, un second composant à courant continu et une seconde valeur moyenne quadratique totale du second courant ; et
**caractérisé en ce que** le procédé comprend en outre les étapes consistant à :

générer (130) un signal de prédiction pour la saturation du transformateur de courant en accord avec le premier vecteur fondamental, le premier composant à courant continu, la première valeur moyenne quadratique totale, le second vecteur fondamental, le second composant à courant continu, et la seconde valeur moyenne quadratique totale,
dans lequel un parmi le premier vecteur fondamental et le second vecteur fondamental dont la phase est en avance est un vecteur de courant en avance, et l'autre est un vecteur de courant en retard,
dans lequel la génération d'un signal de prédiction pour la saturation du transformateur de courant comprend : la génération du signal de prédiction pour la saturation du transformateur de courant quand le premier courant et le second courant satisfont des conditions de jugement de saturation de base et au moins une parmi des conditions de jugement de saturation additionnelles,
dans lequel la condition de jugement de saturation de base comprend l'une au moins des conditions suivantes :

un rapport du premier composant à courant continu sur la première valeur moyenne quadratique totale est plus grand qu'un premier seuil de rapport à courant continu, et une différence angulaire de vecteur de courant, qui est une différence angulaire entre le vecteur de courant d'avance et le vecteur de courant de retard tombe à l'intérieur d'une plage de différence angulaire prédéterminée ; et
un rapport du second composant à courant continu sur la seconde valeur moyenne quadratique totale est plus grand que le seuil de rapport de courant continu, et la différence angulaire du vecteur de courant tombe à l'intérieur de la plage de différence angulaire prédéterminée.

2. Procédé pour prédire une saturation d'un transformateur de courant selon la revendication 1, dans lequel les conditions de jugement de saturation additionnelles comprennent l'une au moins des conditions suivantes :

une valeur moyenne quadratique du vecteur de courant d'avance diminue ; la différence angulaire du vecteur de courant augmente ;
une composante de courant continu d'un courant différentiel qui est une différence entre le premier courant et le second courant augmente ;
un coefficient de corrélation de simultanéité du premier courant et du second courant est plus élevé qu'un premier seuil prédéterminé ; et
un coefficient de corrélation de cycle du premier courant et du second courant est plus grand qu'un second seuil prédéterminé.

3. Procédé pour prédire une saturation d'un transformateur de courant selon la revendication 2, dans lequel la condition selon laquelle la valeur moyenne quadratique du vecteur de courant d'avance diminue comprend au moins une des conditions suivantes :

la valeur moyenne quadratique du vecteur de courant d'avance à un second instant est plus petite qu'un produit de la valeur moyenne quadratique du vecteur de courant d'avance à un premier instant et d'un premier temps prédéterminé ; et
un rapport d'une différence entre la valeur moyenne quadratique du vecteur de courant d'avance au premier instant et la valeur moyenne quadratique du vecteur de courant d'avance au second instant sur la valeur moyenne quadratique du vecteur de courant d'avance au premier instant est plus grand qu'un premier rapport prédéterminé,
dans lequel le premier instant est plus tôt que le second instant.

4. Procédé pour prédire une saturation d'un transformateur de courant selon la revendication 2, dans lequel la condition selon laquelle la différence angulaire du vecteur de courant augmente comprend l'une au moins des conditions suivantes :

la différence angulaire du vecteur de courant à un quatrième instant est plus grande qu'un produit de la différence angulaire du vecteur de courant à un troisième instant et d'un second temps prédéterminé ; et
un rapport d'une différence entre la différence angulaire du vecteur de courant au quatrième instant et la différence angulaire du vecteur de courant au troisième instant sur la différence angulaire du vecteur de courant au troisième instant est plus grand qu'un second rapport prédéterminé,
dans lequel le troisième instant est plus tôt que le quatrième instant.

5. Procédé pour prédire une saturation d'un transformateur de courant selon la revendication 2, dans lequel la condition selon laquelle la composante de courant continu du courant différentiel augmente comprend l'une au moins des conditions suivantes :

la composante de courant continu du courant différentiel à un sixième instant est plus grande qu'un produit de la composante de courant continu du courant différentiel à un cinquième instant et d'un troisième temps prédéterminé ; et
un rapport d'une différence entre la composante de courant continu du courant différentiel au sixième instant et la composante de courant continu du courant différentiel au cinquième instant sur la composante de courant continu du courant différentiel au cinquième instant est plus grand qu'un troisième rapport prédéterminé,
dans lequel le cinquième instant est plus tôt que le sixième instant.

6. Procédé pour prédire une saturation d'un transformateur de courant selon la revendication 1, dans lequel les conditions de jugement de saturation de base comprennent en outre : la valeur moyenne quadratique du vecteur de courant d'avance est plus grande qu'un premier seuil de valeur moyenne quadratique.

7. Procédé pour prédire une saturation d'un transformateur de courant selon la revendication 2, dans lequel les conditions de jugement de saturation additionnelles comprennent en outre l'une au moins des conditions suivantes :

la valeur moyenne quadratique du vecteur de courant d'avance est plus petite qu'un produit de la valeur moyenne quadratique du vecteur de courant de retard et d'un quatrième temps prédéterminé ; et
un rapport de la composante de courant continu du courant différentiel, qui est la différence entre le premier courant et le second courant, sur la valeur moyenne quadratique totale du courant différentiel est plus grand qu'un quatrième rapport prédéterminé.

8. Procédé pour prédire une saturation d'un transformateur de courant selon la revendication 1, dans lequel le signal de prédiction pour la saturation du transformateur de courant identifie un transformateur de courant correspondant au vecteur de courant d'avance.

9.  Procédé pour prédire une saturation d'un transformateur de courant selon l'une quelconque des revendications 1 à 8,
    dans lequel le transformateur est un transformateur triphasé, et chaque phase comprend le premier transformateur de courant et le second transformateur de courant correspondant à la phase.

10. Procédé pour prédire une saturation d'un transformateur de courant selon l'une quelconque des revendications à 8, dans lequel un courant d'appel sympathique s'écoule à travers le transformateur.

<u>100</u>

S101 START

S110

detecting a first current output from the first current transformer and detecting a second current output from the second current transformer

S120

calculating a first fundamental vector, a first DC component and a first total RMS of the first current, and calculating a second fundamental vector, a second DC component and a second total RMS of the second current

S130

generating a prediction signal for the current transformer saturation according to the first fundamental vector, the first DC component, the first total RMS, the second fundamental vector, the second DC component and the second total RMS

S199 END

Fig.1

current transformer saturation prediction alarming

current transformer saturation block signal

basic saturation judgment conditions

&

&

at least one additional saturation judgment condition

|Idiff|>K9

Fig.2

basic saturation judgment condition

|I1|>K0

I1dc/I1rms>Kdc

&

+

&

|I2|>K0

I2dc/I2rms>Kdc

&

Ka<Arg (Ilead)-Arg (Ilag)<Kb

Fig.3

Fig.4

Fig.5

Fig.6

Fig.7

Fig.8

Fig.9A

Fig.9B

Fig.10

EP 2 747 229 B1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 02093710 A1

**Non-patent literature cited in the description**

- **BOGDAN KASZTENNY.** Operate and Restraint Signals of a Transformer Differential Relay. *54th Annual Georgia Tech Protective Relaying Conference,* 05 May 2000